# EUROPÄISCHE PATENTANMELDUNG

(11) **EP 2 040 524 A1**
(43) Veröffentlichungstag der Anmeldung: **25.03.2009**
(21) Anmeldenummer: 07018753.9
(22) Anmeldetag: 24.09.2007
(51) Int. Cl.: H05K 5/00, H05K 3/32, H01R 12/36, H01R 43/16, H01R 43/02

(54) **Verfahren zum Herstellen eines elektronischen Gerätes, insbesondere eines Leistungsmoduls, elektrisches Gerät und Anschlusskontakt**

(71) Anmelder: SIEMENS AKTIENGESELLSCHAFT, 80333 München (DE)
(72) Erfinder: Wöllmer, Heinz, Dr., 9226 Ammerthal (DE)

(57) **Zusammenfassung**

Verfahren zum Herstellen eines elektronischen Gerätes, insbesondere eines Leistungsmoduls ist dadurch gekennzeichnet, dass es die folgenden Schritte aufweist:
i) Bestücken eines Gehäuses (12) mit Anschlusskontakten (81);
ii) Zusammenfügen einer Schaltplatine (13) mit dem mit den Anschlusskontakten (81) bestückten Gehäuse (12); und
iii) stoffschlüssiges Verbinden der Anschlusskontakte (51, 81-131) mit der Schaltplatine (13) jeweils an mindestens einer Kontaktstelle (74).
Ansprüche für elektrisches Gerät und Anschlußkontakt vorhanden.

## Beschreibung

Die Erfindung betrifft ein Verfahren zum Herstellen eines elektronischen Gerätes. Ferner betrifft die Erfindung den Aufbau der Anschlusskontakte und ein elektrisches Gerät mit mindestens einem Anschlußkontakt.

Leistungsmodule, die beispielsweise in elektronischen Schaltgeräten oder in Motorstartgeräten angewendet werden, bestehen aus einer Schaltung, die auf einer flachen Schaltplatine aufgebaut ist. Zur elektrisch leitfähigen Kontaktierung der Schaltplatine mit der Außenwelt sind Anschlusskontakte notwendig. Diese müssen an einem Ende zuverlässig mit der Schaltplatine verbunden sein, an dem anderen Ende erfolgt die Kontaktierung mit der Außenwelt.

Die Anschlusskontakte werden normalerweise durch Anklemmen von weiterführenden Anschlussleitern mittels Schrauben oder Federn kontaktiert, durch Einlöten der Anschlusskontakte in weitere Schaltungsplatinen, oder durch Anschweißen oder Anlöten von weiterführenden Leitern.

In der Regel ist die Schaltplatine in ein elektrisch isolierendes Kunststoffgehäuse eingesetzt, das unter anderem die Schaltplatine und die Anschlusskontakte mechanisch fixiert, die Strombahnen untereinander isoliert, das Modul nach außen beschränkt, die Schaltung vor Umwelteinflüssen schützt und die Verbindung mit weiteren Funktionselementen oder Strukturelementen eines Gerätes ermöglicht.

Häufig ist eine Z-förmige Ausformung des Anschlusskontaktes aus Platzgründen günstig.

Nach dem den Erfindern bekannten Stand der Technik werden die Anschlusskontakte mit den Anschlusspads der Schaltplatine verbunden, dann wird die Schaltplatine mit den verbundenen Anschlusskontakten in das Gehäuse eingesetzt, wobei noch möglicherweise die Anschlusskontakte in deren Endposition gebogen werden. Die Anschlusskontakte können zu einem weiteren Anschlussteil dann mit Schrauben verbunden werden.

Es ist eine Aufgabe der Erfindung, die Fehleranfälligkeit der zu herstellenden elektronischen Geräte, insbesondere von Leistungsmodulen, zu verbessern.

Die Aufgabe kann mit einem Verfahren nach Anspruch 1 gelöst werden. Wenn das Herstellverfahren eines elektronischen Gerätes, insbesondere eines Leistungsmoduls, die folgenden Schritte aufweist: i) Bestücken eines Gehäuses mit Anschlusskontakten, ii) Zusammenfügen einer Schaltplatine mit dem mit den Anschlusskontakten bestückten Gehäuse, und
iii) stoffschlüssiges Verbinden der Anschlusskontakte mit der Schaltplatine jeweils an mindestens einer Kontaktstelle, werden beim Verbinden der Anschlusskontakte mit der Schaltung aufwändige Haltevorrichtungen eingespart.

Die Anschlusskontakte können relativ komplex aufgeformt werden, da die Montage von einzelnen Anschlusskontakten in das Gehäuse vor dem Einsetzen der Schaltung wesentlich einfacher ist. Außerdem können auch Anschlussgeometrien realisierbar sein, die durch nachträgliches Einsetzen in das Gehäuse gar nicht herstellbar sind. Hierdurch kann der Bauraum des Moduls optimiert werden. Nachträgliches Biegen der Anschlusskontakte im bereits mit der Schaltung verbundenen Zustand und zusätzliches Verbinden der Anschlusskontakte mit einem weiteren Anschlussteil wird vermieden. Durch die hohe Gestaltungsfreiheit lässt sich die Gesamtzahl der zu montierenden Teile minimieren.

Ferner kann die Aufgabe mit einem Anschlusskontakt nach Anspruch 7 gelöst werden, nämlich wenn der Anschlusskontakt als L- oder Z-förmiger und zumindest im Übergangsbereich zur Schaltplatine als flexibler Teil mit geringer Materialdicke am Übergang zur Schaltplatine ausgeführt wird.

Die untergeordneten Ansprüche beschreiben vorteilhafte Aspekte des Verfahrens.

Wenn mindestens einer der Anschlusskontakte zumindest im Übergangsbereich zur Schaltplatine als flexibler Teil mit geringer Materialdicke am Übergang zur Schaltplatine ausgeführt wird, können bei mechanischer Belastung der Anschlusskontakte schädliche Krafteinwirkungen auf die Verbindungsstelle zwischen der Schaltplatine und des Anschlusskontakts besser vermieden werden.

Wenn mindestens einer der Anschlusskontakte zumindest im Übergangsbereich zur Schaltplatine aus dünnem Blech besteht, das mechanisch flexibel ist, ist beim Zusammensetzen der Schaltplatine und Gehäuse ein Toleranzausgleich möglich. Dies ist besonders günstig, bei Anschlusskontakten, die nur eine geringe Stromtragfähigkeit aufweisen müssen.

Die geringe Materialdicke im Übergangsbereich kann als ein zusätzlich angefügtes Blech oder durch Dünnprägen des Anschlusskontaktes an dieser Stelle realisiert werden. Dies ist besonders günstig bei Anschlusskontakten mit größerem Querschnitt für hohe Stromtragfähigkeit, da so eine flexible Gestaltung auf eine relativ einfache Weise erfolgen kann.

Das Einsetzen der Anschlusskontakte in das Gehäuse kann automatisiert direkt nach dem Stanzen der Anschlusskontakte ausgeführt werden. Hierdurch wird Handlingsaufwand eingespart, und Anschlusskontakte müssen nicht als Schüttgut vorliegen.

In einer besonders günstigen Ausführungsform des Verfahrens wird der Schritt des stoffschlüssigen Verbindens durch ein schnelles berührungsloses Verfahren, insbesondere durch Laserschweißen, ausgeführt, da der Verfahrensablauf sich sehr gut für derartige Verfahren eignet.

Im Folgenden wird die Erfindung unter Bezugnahme auf die in den beigefügten Zeichnungen dargestellten Beispiele näher erläutert.

Es zeigen:
- FIG 1: schematischer Aufbau eines Leistungsmoduls;
- FIG 2 bis 4: konventioneller Prozessablauf beim Zusammenbau eines Leistungsmoduls;
- FIG 5 bis 7: neuer Prozessablauf beim Zusammenbau eines Leistungsmoduls;
- FIG 8 bis 13: mögliche Ausführungsformen von Anschlusskontakten, die im Gehäuse vorbestückt werden können; und
- FIG 14: komplex ausgeformte Anschlusskontakte.

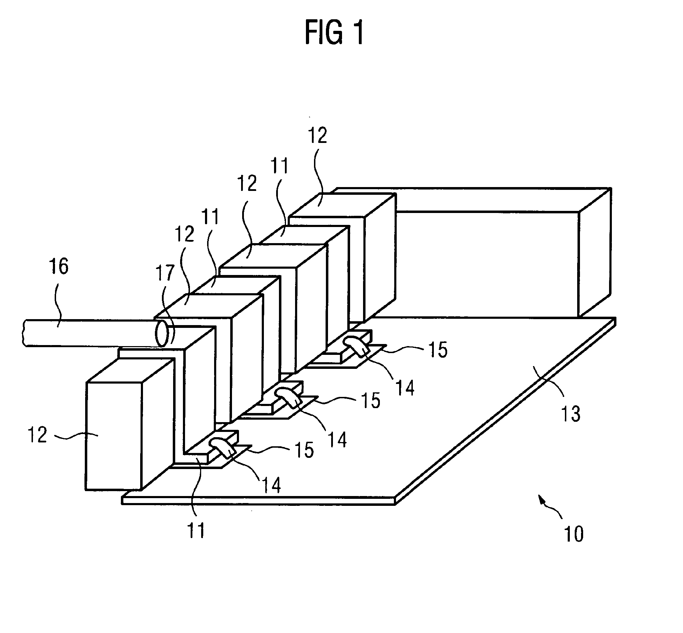

FIG 1 zeigt den schematischen Aufbau eines Leistungsmoduls 10 in perspektivischer Ansicht. Anschlusskontakte 11 sind in einem Gehäuse 12 fixiert und über eine leitfähige, stoffschlüssige Verbindung 14 auf dem Anschlusspad 15 mit der Schaltplatine 13 verbunden. Über die Kontaktstelle 17 zum Außenanschluss wird der Anschluss 16 verbunden, der aus weiterführenden Leitern besteht.

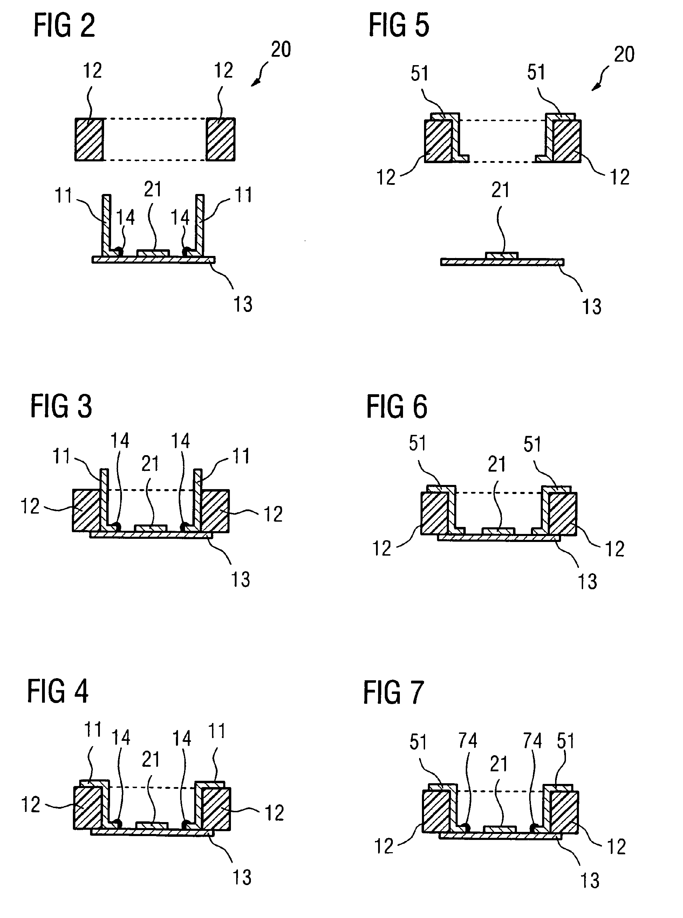

Der konventionelle Prozessablauf beim Zusammenbau eines Leistungsmoduls 10 wird in FIG 2 bis 4 näher beschrieben. Die in FIG 2 dargestellten, vorher an mindestens einer Kontaktstelle 14 stoffschlüssig mit der Schaltplatine 13 verbundenen, Anschlusskontakte 11 werden zusammen mit der Schaltplatine 13 in ein Gehäuse 12 gesetzt (FIG 3) und anschließend (FIG 4) in die Endposition gebogen.

Die Schaltplatine 13 weist mindestens ein integriertes Halbleiterschaltmodul 21 auf. Wenn das herzustellende elektronische Gerät ein Leistungsmodul ist, ist das Halbleiterschaltmodul 21 ausgebildet, einen elektrischen Strom zu schalten, bevorzugt im Bereich bis zu hundert Ampere. Das Halbleiterschaltmodul 21 kann als Thyristor ausgeführt werden.

Der neue Prozessablauf beim Zusammenbau eines elektronischen Gerätes, insbesondere eines Leistungsmoduls, wird in FIG 5 bis 7 näher beschrieben. Das Gehäuse 12 wird mit Anschlusskontakten 51 bestückt (FIG 5), dann wird die Schaltplatine 13 mit dem mit Anschlusskontakten 51 bestückten Gehäuse 12 zusammengefügt (FIG 6), wonach die Anschlusskontakte 51 an mindestens einer Kontaktstelle 74 stoffschlüssig mit der Schaltplatine 13 verbunden werden.

Mit anderen Worten, das Herstellungsverfahren umfasst die folgenden Schritte: Bestücken der fertig gebogenen Anschlüsse in das Gehäuse, Einsetzen der Schaltung in das Gehäuse, Anschweißen der Anschlüsse auf die Anschlusspads der Schaltung, vorzugsweise mit Laserstrahlung.

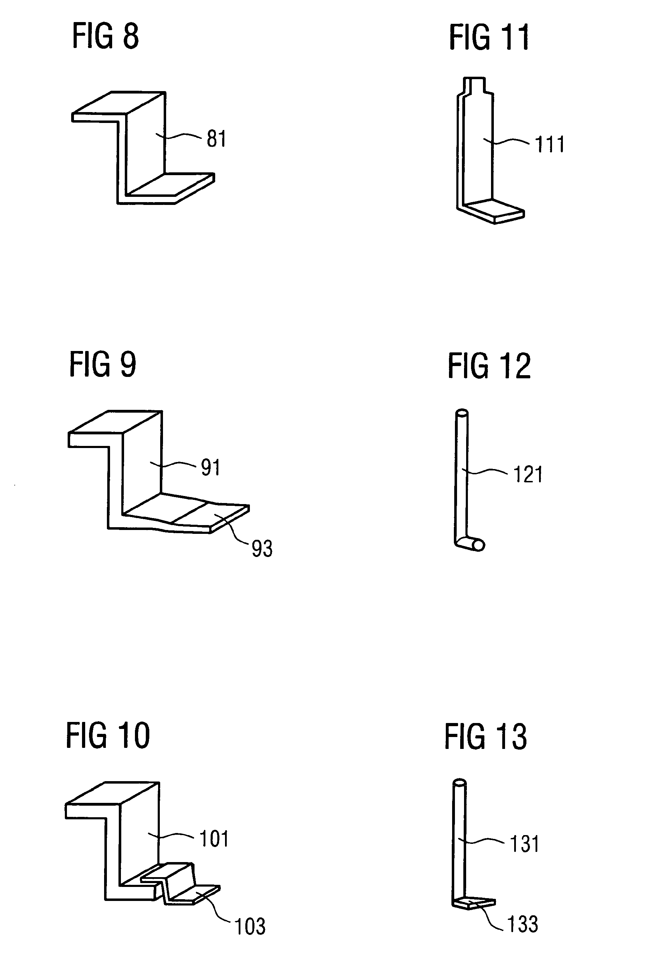

FIG 8 bis 13 zeigen einige mögliche Ausführungsformen von Anschlusskontakten 81, 91, 101, 111, 121, 131, die im Gehäuse 12 vorbestückt werden können.

In FIG 9 ist der Anschlusskontakt 91 dünngeprägt und weist daher einen Bereich 93 mit niedrigerer Materialdicke auf.

In FIG 10 weist der Anschlusskontakt 101 zusätzlich ein dünnes Blech 103 auf, das materialschlüssig, beispielsweise durch Laserschweißen, mit dem Anschlusskontakt 101 verbunden ist.

FIG 11 zeigt eine Ausführungsform der Erfindung, in der der Anschlußkontakt 111 ein L-förmig gebogenes Blech aufweist.

FIG 12 zwigt eine Ausführungsform der Erfindung, in der der Anschlußkontakt 121 einen L-förmig gebogenen Draht aufweist.

Auch in FIG 13 ist der Anschlusskontakt 131 dünngeprägt und weist daher einen Bereich 133 mit niedrigerer Materialdicke auf.

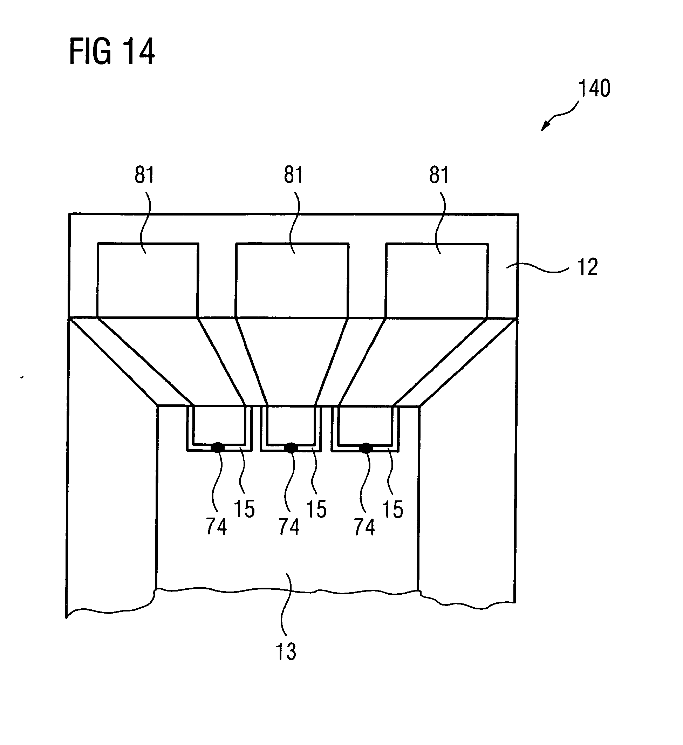

In FIG 14 ist ein Leistungsmodul 140 mit komplex ausgeformten Anschlusskontakten 81 dargestellt. Das Gehäuse 12 wurde zuerst mit den Anschlusskontakten 81 bestückt, dann wurde die Schaltplatine 13 mit dem mit den Anschlusskontakten 81 bestückten Gehäuse 12 zusammengefügt. Danach wurden die Anschlusskontakte 51 jeweils an einer Kontaktstelle 74 stoffschlüssig mit der Schaltplatine 13 verbunden.

## Patentansprüche

1. Verfahren zum Herstellen eines elektronischen Gerätes, insbesondere eines Leistungsmoduls, **dadurch gekennzeichnet, dass** das Verfahren die folgenden Schritte aufweist:
i) Bestücken eines Gehäuses (12) mit Anschlusskontakten (81) ;
ii) Zusammenfügen einer Schaltplatine (13) mit dem mit den Anschlusskontakten (81) bestückten Gehäuse (12); und
iii) stoffschlüssiges Verbinden der Anschlusskontakte (51, 81-131) mit der Schaltplatine (13) jeweils an mindestens einer Kontaktstelle (74).

2. Verfahren nach Anspruch 1, **wobei** mindestens einer der Anschlusskontakte (51, 81-131) zumindest im Übergangsbereich zur Schaltplatine als flexibler Teil mit geringer Materialdicke am Übergang zur Schaltplatine ausgeführt ist.

3. Verfahren nach Anspruch 1 oder 2, **wobei** mindestens einer der Anschlusskontakte (51, 81-131) zumindest im Übergangsbereich zur Schaltplatine aus dünnem Blech besteht, das mechanisch flexibel ist.

4. Verfahren nach einem der vorhergehenden Ansprüche, **wobei** die geringe Materialdicke im Übergangsbereich als ein zusätzlich angefügtes Blech oder durch Dünnprägen des Anschlusskontaktes an dieser Stelle ausgeführt wird.

5. Verfahren nach einem der vorhergehenden Ansprüche, **wobei** das Einsetzen der Anschlusskontakte (51, 81-131) in das Gehäuse (12) automatisiert direkt nach dem Stanzen der Anschlusskontakte (51, 81-131) ausgeführt wird.

6. Verfahren nach einem der vorhergehenden Ansprüche, **wobei** der Schritt des stoffschlüssigen Verbindens durch schnelles berührungsloses Verfahren, insbesondere durch Laserschweißen, ausgeführt wird.

7. Anschlusskontakt (51, 81-131) für ein elektronisches Gerät, insbesondere für ein Leistungsmodul, **dadurch gekennzeichnet,** der Anschlusskontakt als L- oder Z-förmiger und zumindest im Übergangsbereich zur Schaltplatine als flexibler Teil mit geringer Materialdicke am Übergang zur Schaltplatine ausgeführt wird.

8. Anschlusskontakt (51, 81-131) nach Anspruch 7, **wobei** der Anschlusskontakt (51, 81-131) zumindest im Übergangsbereich zur Schaltplatine aus dünnem Blech (93, 103, 133) besteht, das mechanisch flexibel ist.

9. Anschlusskontakt (51, 81-131) nach Anspruch 7 oder 8, **wobei** die geringe Materialdicke im Übergangsbereich als ein zusätzlich angefügtes Blech (103) oder durch Dünnprägen des Anschlusskontaktes (91, 93; 131, 133) an dieser Stelle ausgeführt wird.

10. Elektronisches Gerät, insbesondere ein Schaltgerät zum mehrphasigen Schalten eines Stromkreises oder ein Motorstartgerät, mit mindestens einem Anschlusskontakt nach einem der vorhergehenden Ansprüche 7 bis 9.
